# EUROPEAN PATENT SPECIFICATION

(11) **EP 1 891 691 B1**
(45) Date of publication and mention of the grant of the patent: **01.08.2012**
(21) Application number: 06745035.3
(22) Date of filing: 30.05.2006
(51) Int. Cl.: H01L 51/52

(54) **ORGANIC ELECTROLUMINESCENT LIGHT SOURCE**
ORGANISCHE ELEKTROLUMINESZENTE LICHTQUELLE
SOURCE LUMINEUSE ELECTROLUMINESCENTE ORGANIQUE

(30) Priority: 03.06.2005 EP 05104861
(43) Date of publication of application: 27.02.2008
(73) Proprietor: Philips Intellectual Property & Standards GmbH, 20099 Hamburg (DE); Koninklijke Philips Electronics N.V., 5621 BA Eindhoven (NL)
(72) Inventor: GREINER, Horst, 52066 Aachen (DE)
(74) Representative: Bekkers, Joost J.J
(86) International application number: PCT/IB2006/051705
(87) International publication number: WO 2006/129265

(56) References cited:
- EP-A2- 1 347 518
- US-A1- 2004 199 016
- US-B1- 6 670 054
- PENG H J ET AL: "COUPLING EFFICIENCY ENHANCEMENT OF ORGANIC LIGHT EMITTING DEVICES WITH REFRACTIVE MICROLENS ARRAY ON HIGH INDEX GLASS SUBSTRATE" 2004 SID INTERNATIONAL SYMPOSIUM DIGEST OF TECHNICAL PAPERS. SEATTLE, WA, MAY 25 - 27, 2004, SID INTERNATIONAL SYMPOSIUM DIGEST OF TECHNICAL PAPERS, SAN JOSE, CA : SID, US, vol. VOL. 35 PRT 1, 25 May 2004 (2004-05-25), pages 158-161, XP001222788

## Description

The invention relates to electroluminescent light sources having organic layers to improve the light extraction.

A multiplicity of electroluminescent light sources with organic layers (OLEDs) are known, which comprise a substrate, at least two electrodes and an organic electroluminescent layer arranged between the electrodes. Light is typically generated in the electroluminescent layer by applying an operating voltage, and is emitted through a transparent substrate. Such so-called bottom emitters correspondingly have a transparent electrode, usually the anode, arranged between the substrate and the electroluminescent layer, and a reflective second electrode, usually the cathode. Owing to the optical properties, for example refractive index, of the substrate, anode and electroluminescent layer and the reflecting power of the cathode, only a part of the light generated in the electroluminescent layer with a typical layer thickness of between 50 nm and 150 nm is extracted from the electroluminescent light source. Approximately 1/3 of the light is lost without radiation at the reflective electrode (typically the cathode), 1/3 of the light remains in the organic · electroluminescent layer and 1/3 of the light is extracted into the substrate. Owing to additional light losses at the interface between the substrate and the air, in typical OLEDs only between 20% and 25% of the light generated in the organic electroluminescent layer is extracted from the OLED.

A multiplicity of different methods, for example special surface structures of the substrate, layers for light scattering between the transparent electrode and the substrate and/or so-called microcavity structures for influencing the emission direction of the light in the electroluminescent layer, are used in order to increase the light extraction. All known methods for increasing the luminous efficiency (fraction of extracted light relative to the amount of light generated in the organic electroluminescent layer) aim for maximum extraction of the light present at the interface between the electroluminescent light source and the transparent electrode. Document US 20050062399A1 discloses an additional layer structure between the anode and the substrate to modify the waveform of the light generated in the organic electroluminescent layer. Although these measures can increase the luminous efficiency perpendicularly to the layer surface by a factor of 7/3 at the cost of the other light propagation directions, the known methods can only achieve a maximum increase in the overall luminous efficiency by a factor of 1.5 integrally over all the light propagation directions. With an original luminous efficiency of up to 25%, this corresponds to an improvement of to up to 38%. Therefore, more than half of the generated light is still not extracted from the electroluminescent light source and is thus lost from the luminous efficiency. In this context, a further increase in the luminous efficiency is desirable.

EP 1347518 discloses an electroluminescent light source comprising a transparent substrate, a transparent electrode, a reflective electrode and at least one organic electroluminescent layer for emitting light, with a thickness of more than 250 nm, preferably more than 400 nm, particularly preferably more than 500 nm, arranged between the electrodes. The electroluminescent layer comprises one hole-conductive layer (HTL) and one electron-conductive layer (ETL).

It is therefore an object of the invention to provide an organic electroluminescent light source having an improved luminous efficiency.

This object is achieved by an electroluminescent light source according to claim 1 and comprising a transparent substrate, a transparent electrode and a reflective electrode, and at least one organic electroluminescent layer for emitting light, with a thickness of more than 250 nm, preferably more than 400 nm, particularly preferably more than 500 nm, to reduce the light losses at the reflective electrode. The non-radiative transitions of excited states in the organic electroluminescent layer, due to coupling with surface plasmons (collective excitation of the conduction electrode gas in a metal) of the cathode, can be minimized by increasing the distance from the electron and hole recombination zone to the cathode, which correspondingly leads to a reduction of the light losses at the reflective electrode. To a first approximation, the recombination zone lies in the middle of the organic electroluminescent layer.

The organic electroluminescent layer also comprises at least one hole-conductive layer and one electron-conductive layer, the thickness of the electron-conductive layer being more than 200 nm, preferably more than 250 nm, particularly preferably more than 300 nm. Hole-conductive layers will be referred to below as HTL layers, and electron-conductive layers as ETL layers. In the case of ETL and HTL layers with similar conductivity properties, the recombination zone typically lies close to the interface between the ETL and HTL layers. Here, the distance from the recombination zone to the cathode is proportional to the thickness of the ETL layer.

In the electroluminescent light source, the thickness of the hole-conductive layer is more than 90 nm, preferably more than 150 nm, particularly preferably more than 200 nm. Experiments have shown that with a fixed ETL layer thickness, the luminous efficiency (fraction of the light extracted into the substrate relative to the amount of light generated in the organic electroluminescent layer) can be improved by 15% by suitable selection of the HTL layer thickness.

The electron-conductive layer and the hole-conductive layer have a refractive indexes n_{E} (ETL) and n_{L} (HTL) with a difference |n_{E} - n_{L}| ≤ 0.1. Experiments have shown that the luminous efficiency becomes particularly high when the refractive index difference between the ETL and HTL layers is as small as possible.

It is in this case particularly preferable for the electron-conductive layer to contain n-type dopants, preferably metals, and/or for the hole-conductive layer to contain p-type dopants, preferably organic materials, to increase the conductivity. By means of dopants in the ETL and HTL layers, the electrical conductivity of these layers can be adapted to large layer thicknesses, so that essentially the same operating voltages can be achieved as with small layer thickness.

In a preferred embodiment of an electroluminescent light source, the organic electroluminescent layer has a layer thickness of less than 1,000 nm, preferably less than 800 nm, particularly preferably less than 600 nm. The electrical properties can be adjusted advantageously if the overall layer thickness is as small as possible.

In another preferred embodiment, the transparent substrate has a refractive index of more than 1.6, preferably more than 1.8. The luminous efficiency can be increased significantly by substrates with higher refractive indexes.

In a particularly preferred embodiment of an electroluminescent light source, the difference between the refractive indexes of the transparent substrate, the transparent electrode and the organic electroluminescent layer is less than 0.1, and they are preferably identical. In this way, the light losses due to reflection at the interfaces inside the electroluminescent light source can be reduced or avoided.

It is in this case more preferable for the reflective electrode of the electroluminescent light source to have a reflectivity of more than 90%. The likelihood that the light reflected back by the substrate/air interface will be extracted from the electroluminescent light source, after arriving at this interface again, is commensurately greater when the reflectivity of the corresponding back-reflecting electrode is higher.

It is in this case particularly preferable for the substrate to have a light extraction structure at the interface with the air. With an extraction structure of this kind it is possible for the light injected into the substrate to be extracted almost fully out of the electroluminescent light source.

These and other aspects of the invention are apparent from and will be elucidated with reference to the embodiments described hereinafter.

In the drawings:
Fig. 1 shows an electroluminescent light source according to the invention,
Fig. 2 shows the luminous efficiency when extracting the light into the substrate as a function of the ETL layer thickness for a substrate with a refractive index n = 1.7,
Fig. 3 shows the luminous efficiency when extracting the light into the substrate as a function of the ETL layer thickness for a substrate with a refractive index n = 1.5,
Fig. 4 shows the luminous efficiency when extracting the light into the substrate as a function of the ETL layer thickness, with a refractive index n of 1.9 and 1.7 respectively for the HTL layer and the ETL layer and n = 1.7 for the substrate.

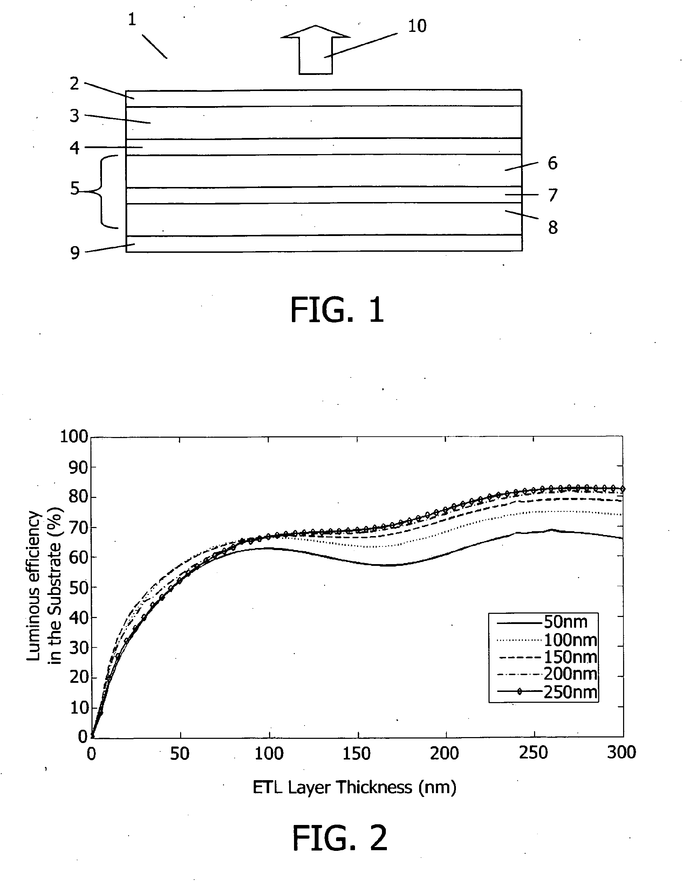

Fig. 1 shows a so-called bottom-emitting electroluminescent light source, which generally consists of a layer structure, applied on a planar transparent substrate 3, comprising at least one organic electroluminescent layer 5 which is arranged between a transparent electrode 4 and an at least partially reflective electrode 9. The refractive index of the transparent substrate may vary between 1.4 and 2.0, for example borosilicate glass with n = 1.45, PMMA with n = 1.49, PET with n = 1.65 and high-index Schott glasses such as SF57 with n = 1.85. The organic electroluminescent layer 5 is typically made of a plurality of sublayers 6 to 8. In the case of organic electroluminescent layers 5, an electron injection layer of a material with a low work function may additionally be arranged between the electrode 9, typically the cathode, and the electroluminescent layer 5, and a hole injection layer may additionally be arranged between the electrode 4, typically the anode, and the electroluminescent layer 5. In a bottom-emitting light source, the light 10 reaches the observer through the substrate 3.

Electroluminescent light sources 1 with an increased luminous efficiency generally have a light extraction structure 2 to improve the luminous efficiency on the side of the substrate 3 facing the air. The light extraction structure 2 may comprise square pyramid structures, triangular pyramid structures, hexagonal pyramid structures, ellipsoidal dome structures and/or conical structures. Layers structured in this way may, for example, be manufactured by injection molding methods and laminated onto the substrate. A material which has a refractive index greater than or equal to the refractive index of the substrate is preferable for the light extraction layer 2, in order to avoid total reflection at the interface between the second light extraction layer and the substrate. A material with the same refractive index as the substrate is preferable, in order to keep the refractive index difference from the air as small as possible so as to minimize the fraction of light that is reflected at the interface with the air. In other embodiments, light extraction layers 2 may also be designed as particle layers of a transparent matrix material and light-scattering particles, for example reflective particles and/or particles with a different refractive index than the matrix material.

As an alternative to this, it is moreover possible to apply such light extraction structures 2 directly on the substrate by means of thin-film, lithography and/or sawing processes, in order to avoid an additional light extraction layer.

The transparent electrode 4 may, for example contain p-doped silicon, indium-doped tin oxide (ITO) or antimony-doped tin oxide (ATO). It is also possible to make the transparent electrode 4 from an organic material with a particularly high electrical conductivity, for example poly(3,4-ethylene dioxythiophene) in polystyrene sulfonic acid (PEDT/PSS, Baytron P from HC Starck). The electrode 4 preferably consists of ITO with a refractive index of between 1.6 and 2.0. The reflective electrode 9 may either itself be reflective, for example made of a material such as aluminum, copper, silver or gold, or it may additionally have a reflective layer structure. If the reflective layer or layer structure is arranged below the electrode 9, as viewed in the light emission direction 10, the electrode 9 may also be transparent. The electrode 9 may be structured and, for example, contain a multiplicity of parallel strips of the conductive material or materials. Alternatively, the electrode 9 may be unstructured and designed as a flat surface.

Light-emitting polymers (PLEDs) or small light-emitting organic molecules, which are embedded in an organic hole- or electron-transporting matrix material, may for example be used as the organic material for the electroluminescent layer 5. An OLED with small light-emitting molecules in the organic electroluminescent layer is also referred to as a SMOLED (small molecule organic light-emitting diode). In the layer, holes and electrons encounter one another and recombine. By material-dependent electronic coupling of the light-emitting material to the matrix material, the light-emitting material is excited either directly or via energy transfer. The excited light-emitting material returns to the ground state by emitting light. In order to improve the efficiency, the organic electroluminescent layer 5 of a typical electroluminescent light source 1 comprises a hole-transporting layer 6 (HTL layer), a recombination layer 7 (EL layer) and an electron-transporting layer 8 (ETL layer), the recombination layer 7 being arranged between the HTL and ETL layers. The ETL layer 8 lies between the recombination layer 7 and the cathode 9, and the HTL layer 6 lies between the recombination layer 7 and the anode 4.

For example, 4,4',4"-tris-(N-(3-methyl-phenyl)-N-phenylamino)-triphenylamine (MTDATA) doped with tetrafluoro-tetracyano-quinodimethane (F4-TCNQ) and a hole-transport layer of, for example, triarylamines, diarylamines, tristilbeneamines or a mixture of polyethylene dioxythiophene (PDOT) and poly(styrene sulfonate), is used as the material for the HTL layer 6.

For example, tris-(8-hydroxy-quinolinato)-aluminum (Alq₃), 1,3,5-tris-(1-phenyl-1H-benzimidazol-2-yl)benzene (TPBI) or low-electron heterocycles such as 1,3,4-oxadiazoles or 1,2,4-triazoles, are used as the material for an ETL layer 8.

In the embodiment as a so-called SMOLED layer, the recombination layer 7 may for example comprise iridium complexes as light-emitting material embedded in a matrix material, for example 4,4',4"-tri(N-carbazolyl)triphenylamine (TCTA), 2,9-dimethyl-4,7-diphenyl-1,10-phenanthroline (BCP) or 1,3,5-tris-(1-phenyl-1H-benzimidazol-2-yl)benzene (TPBI) or N,N-diphenyl-N,N-di-(3-methyl-phenyl)-benzidine (TPD). The present invention is independent of the excitation mechanism for the light emission.

Conventional electroluminescent light sources comprise HTL layers with thicknesses of between 30 nm and 65 nm, and ETL layers with thicknesses of between 40 nm and 80 nm. Together with the recombination layer 7, conventional organic electroluminescent layers 5 have a total thickness of between 100 nm and 150 nm. Owing to the charge transport properties and the intended effective light generation, the organic electroluminescent layer 5 has previously been selected to be as thin as possible.

An electroluminescent light source 1 according to the invention, however, has an organic electroluminescent layer 5 for emitting light with a thickness of more than 300 nm, preferably more than 400 nm, particularly preferably more than 500 nm. The non-radiative transitions of excited states in the organic layer, due to coupling with surface plasmons (collective excitation of the conduction electrode gas in a metal) of the cathode, can be minimized by increasing the distance from the electron and hole recombination zone, which correspondingly leads to a reduction of the light losses at the reflective electrode. In the case of ETL and HTL layers with similar conductivity properties, the recombination zone typically lies close to the interface between the ETL and HTL layers. Here, the distance from the recombination zone to the cathode is proportional to the thickness of the ETL layer.

The organic electroluminescent layer 5 shown in Fig. 1 has a so-called pin structure of a doped hole-conductive HTL layer 6, a recombination layer 7 for emitting light 10, where the electron and hole recombination zone essentially lies, and a doped electron-conductive ETL layer 8. Owing to this layer structure, the recombination zone is at a defined distance from the cathode, which essentially corresponds to the thickness of the ETL layer.

Fig. 2 shows the percentage fraction of the light generated in the organic electroluminescent layer 5 which is extracted from the transparent electrode 4 into the substrate 3, as a function of the thickness of the ETL layer 8 for various HTL layer thicknesses 6. Here, the substrate 3 has a refractive index of 1.7 and the transparent electrode 4 has a refractive index of 1.9. The data for different HTL layer thicknesses are represented as follows: 50 nm as a continuous line, 100 nm as a dotted line, 150 nm as a dashed line, 200 nm as a dot-and-dash line and 250 nm as a line with diamond markers.

As can be seen from Fig. 2, maximum light extraction into the substrate of 65% is achieved with conventional HTL/ETL layer thicknesses of 50 nm/80 nm, here with an identical refractive index of 1.75, which corresponds to a luminous efficiency of about 45% in air. The amount of light extracted into the substrate 3 reaches a maximum at ETL layer thicknesses of around 250 nm. Depending on the HTL layer thickness 6, the light extraction falls off again slightly or remains approximately constant for larger ETL layer thicknesses 8. A significant increase in the fraction of the light which is extracted into the substrate 3 is achieved for HTL layer thicknesses of more than 90 nm. With HTL layer thicknesses 6 of more than 200 nm, over 80% of the light generated in the electroluminescent layer 5 can be extracted into the substrate 3 with an optimized ETL layer thickness. With a light extraction layer having an optimized light extraction structure 2 arranged on the substrate, the light injected into the substrate can for the most part be extracted from the electroluminescent light source 1. The amount of light extracted from the electroluminescent light source also depends on the reflectivity of the cathode. With conventional aluminum cathodes having a reflectivity of 80%-85%, a luminous efficiency of more than 60% is obtained for the electroluminescent light source with light extraction into air. With cathode reflectivities of more than 90%, for example gold cathodes with a reflectivity of up to 95%, this value can be increased to more than 65%. It is also preferable that the light extraction into the substrate 3 in the visible spectral range should depend only insubstantially on the wavelength.

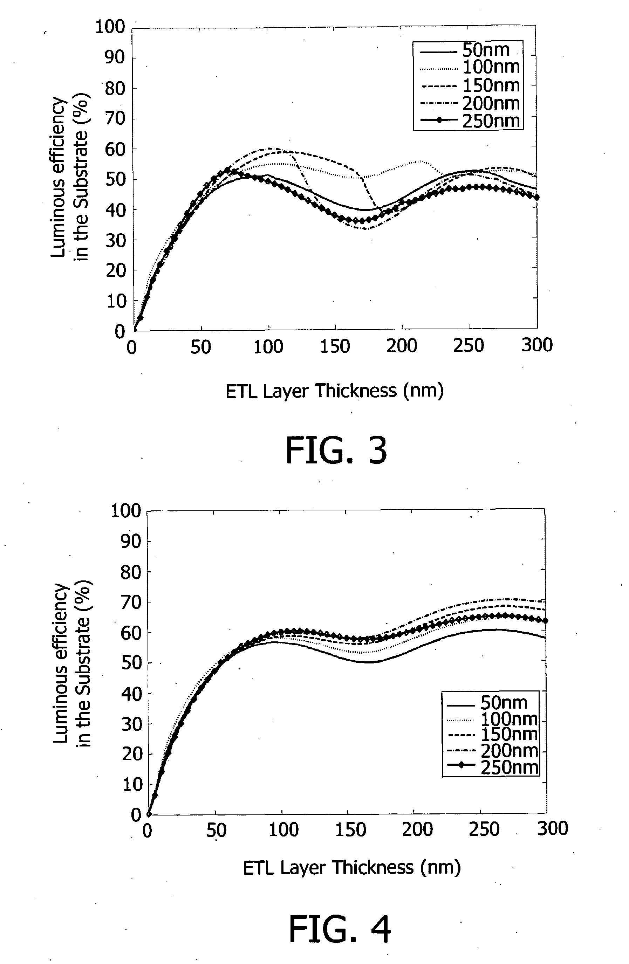

The effect of the refractive index of the substrate 3 can be seen in Fig. 3. Like Fig. 2, Fig. 3 shows the percentage fraction of the light of an organic electroluminescent light source 1 which is extracted from the transparent electrode 4 into the substrate 3, as a function of the thickness of the ETL layer 8 for various HTL layer thicknesses 6, but here with the substrate having a refractive index of 1.5. The data for different HTL layer thicknesses are represented as follows: 50 nm as a continuous line, 100 nm as a dotted line, 150 nm as a dashed line, 200 nm as a dot-and-dash line and 250 nm as a line with diamond markers. Although the variation of the ETL layer thickness has a small effect on the luminous efficiency compared to Fig. 2, for an HTL layer thickness of between 150 nm and 200 nm the luminous efficiency can be increased by about 10% with an ETL layer thickness of from 100 nm to 120 nm, compared to typical layer thicknesses for an electroluminescent device according to the prior art, but without achieving the same high luminous efficiencies of more than 80% as with a substrate having a refractive index of 1.7.

The effect of different refractive indexes of the ETL and HTL layers is represented in Fig. 4 for example for an ETL layer with a refractive index of 1.7 and an HTL layer with a refractive index of 1.9. As in the previous figures, Fig. 4 shows the percentage fraction of the light of an organic electroluminescent light source 1 which is extracted from the transparent electrode 4 into the substrate 3, as a function of the thickness of the ETL layer 8 for various HTL layer thicknesses 6. The refractive index of the substrate is 1.7. The data for different HTL layer thicknesses are represented as follows: 50 nm as a continuous line, 100 nm as a dotted line, 150 nm as a dashed line, 200 nm as a dot-and-dash line and 250 nm as a line with diamond markers. A similar dependency of the luminous efficiency on the ETL layer thickness is found as in Fig. 2, although at most 70% of the light is extracted into the substrate for an optimal ETL layer thickness of approximately 250 nm, which is more than 10% less than with HTL/ETL layers having identical refractive indexes. The optimal HTL layer thickness is here between 150 nm and 200 nm. This optimal HTL layer thickness varies with the difference between the refractive indexes of the ETL and HTL layers.

In a particularly preferred embodiment in which the substrate 3, the transparent electrode 4 and the organic electroluminescent layer 5 have almost the same refractive indexes, preferably equal refractive indexes, about 90% of the light generated in the organic electroluminescent layer 5 can be extracted into the substrate. With a correspondingly optimized light extraction structure 2 of the substrate, which may also be applied on the substrate as a light extraction layer with a light extraction structure 2, a luminous efficiency of between 60% and 68% is obtained for the organic electroluminescent light source 1, and even between 65% and 72% with gold cathodes, which represents a drastic improvement over the prior art. Organic electroluminescent layers typically have a refractive index of between 1.7 and 1.8, and transparent electrodes e.g. of ITO typically have a refractive index of between 1.8 and 2.0. Depending on the material, the refractive index of substrates can vary between 1.4 and 3.0. In a corresponding particularly preferred embodiment, the substrate, the transparent electrode and the organic electroluminescent layer therefore have a refractive index of 1.8.

In another embodiment, additional layers to improve the light extraction from the substrate may be arranged between the transparent electrode 4 and the substrate 3, for example a high-index polymer layer with a thickness of the order of a tens of µm, which contains light-scattering particles in a small concentration.

With layer thicknesses of up to 1,000 nm for the organic electroluminescent layer 5, the electrical conductivities can be improved by means of so-called n-type and/or p-type dopants for the respective hole- and electron-conductive HTL and ETL layers. A layer thickness of less than 1,000 nm including the optimal layer thicknesses for ETL and HTL layers 6 and 8 is therefore advantageous. The layer thickness of the organic electroluminescent layer 5 is preferably less than 800 nm, particularly preferably less than 600 nm. This nevertheless still corresponds to a layer thickness of the organic electroluminescent layer 5 greater by a factor of more than 3 compared to the prior art. For example, high conductivities can be achieved in HTL layers 6 with 4,4',4"-tris-(3-methylphenylphenylamino)-triphenylamine (m-MTDATA) doped with 2 mol% of tetrafluoro-tetracyano-quinodimethane (F₄-TCNQ). In ETL layers 8, high conductivities can be achieved for example by means of Li doping in a 4,7-diphenyl-1,10-phenantroline (BPhen) layer with a doping concentration of 1 Li atom to 1 Bphen molecule. Correspondingly doped organic layers show a rise in the voltage drop across the layer thickness of approximately 0.1 V per 100 nm of additional layer thickness. With a triple layer thickness of the organic electroluminescent layer 5 (600 nm instead of 200 nm) and conventional operating voltages of between 4 V and 8 V, the layer thickness increase corresponds to an operating voltage rise of less than 10%.

The various doping levels can be adjusted by known technologies, for example simultaneous electron beam evaporation with corresponding evaporation rate control by means of quartz oscillator monitors. The doping levels mentioned above by way of example depend on the intended operating voltage and the intended light generation rate, and may be adapted according to the respective requirements.

The embodiments explained above with reference to the figures and the description merely represent examples of improving the light extraction from an electroluminescent light source, and should not be interpreted as restricting the patent claims to these examples. Alternative embodiments, which are likewise covered by the protective scope of the patent claims, are also possible for the person skilled in the art. The numbering of the dependent claims is not meant to imply that other combinations of the claims cannot represent advantageous embodiments of the invention.

## Claims

1. An electroluminescent light source comprising a transparent substrate (3), a transparent electrode (4), a reflective electrode (9) and at least one organic electroluminescent layer (5) for emitting light, with a thickness of more than 250 nm, preferably more than 400 nm, particularly preferably more than 500 nm, arranged between the electrodes (4, 9), whereby the electroluminescent layer (5) comprises at least one hole-conductive layer (6) and one electron-conductive layer (8), **characterized in that** the thickness of the electron-conductive layer (8) being more than 200 nm, preferably more than 250 nm, particularly preferably more than 300 nm, and wherein the electron-conductive layer (8) and the hole-conductive layer (6) have refractive indexes n_{E} and n_{L} with a difference |n_{E} - n_{L}| ≤ 0.1.

2. An electroluminescent light source as claimed in claim 1, **characterized in that** the thickness of the hole-conductive layer (6) is more than 90 nm, preferably more than 150 nm, particularly preferably more than 200 nm.

3. An electroluminescent light source as claimed in any one of the preceding claims 1 to 3, **characterized in that** the electron-conductive layer (8) contains n-type dopants, preferably metals, and/or the hole-conductive layer (6) contains p-type dopants, preferably organic materials, to increase the conductivity.

4. An electroluminescent light source as claimed in any one of the preceding claims, **characterized in that** the organic electroluminescent layer (5) has a layer thickness of less than 1,000 nm, preferably less than 800 nm, particularly preferably less than 600 nm.

5. An electroluminescent light source as claimed in any one of the preceding claims, **characterized in that** the transparent substrate (3) has a refractive index of more than 1.6, preferably more than 1.8.

6. An electroluminescent light source as claimed in any one of the preceding claims, **characterized in that** the refractive indexes of the transparent substrate (3), the transparent electrode (4) and the organic electroluminescent layer (5) differ by less than 0.1, and are preferably identical.

7. An electroluminescent light source as claimed in any one of the preceding claims, **characterized in that** the reflective electrode (9) has a reflectivity of more than 90%.

8. An electroluminescent light source as claimed in any one of the preceding claims, **characterized in that** the substrate (3) has a light extraction structure (2) at the interface with the air.

## Patentansprüche

1. Elektrolumineszenzlichtquelle mit einem transparenten Substrat (3), einer transparenten Elektrode (4), einer reflektierenden Elektrode (9) und mindestens einer organischen Elektrolumineszenzschicht (5) zum Emittieren von Licht, die eine Dicke von mehr als 250 nm, besser noch mehr als 400 nm, am besten mehr als 500 nm, aufweist und zwischen den Elektroden (4, 9) angeordnet ist, wobei die Elektrolumineszenzschicht (5) mindestens eine löcherleitende Schicht (6) und eine elektronenleitende Schicht (8) umfasst, **dadurch gekennzeichnet, dass** die Dicke der elektronenleitenden Schicht (8) mehr als 200 nm, besser noch mehr als 250 nm, am besten mehr als 300 nm, beträgt, und wobei die elektronenleitende Schicht (8) und die löcherleitende Schicht (6) Brechungsindizes n_{E} und n_{L} mit einer Differenz |n_{E} - n_{L}| ≤ 0,1 aufweisen.

2. Elektrolumineszenzlichtquelle nach Anspruch 1, **dadurch gekennzeichnet, dass** die Dicke der löcherleitenden Schicht (6) mehr als 90 nm, besser noch mehr als 150 nm, am besten mehr als 200 nm, beträgt.

3. Elektrolumineszenzlichtquelle nach einem der vorangegangenen Ansprüche 1 bis 3, **dadurch gekennzeichnet, dass** die elektronenleitende Schicht (8) n-Typ-Dotierungsstoffe, vorzugsweise Metalle, und/oder die löcherleitende Schicht (6) p-Typ-Dotierungsstoffe, vorzugsweise organische Materialien, enthält, um die Leitfähigkeit zu erhöhen.

4. Elektrolumineszenzlichtquelle nach einem der vorangegangenen Ansprüche, **dadurch gekennzeichnet, dass** die organische Elektrolumineszenzschicht (5) eine Schichtdicke von weniger als 1.000 nm, noch besser weniger als 800 nm, am besten weniger als 600 nm, aufweist.

5. Elektrolumineszenzlichtquelle nach einem der vorangegangenen Ansprüche, **dadurch gekennzeichnet, dass** das transparente Substrat (3) einen Brechungsindex von mehr als 1,6, vorzugsweise mehr als 1,8, aufweist.

6. Elektrolumineszenzlichtquelle nach einem der vorangegangenen Ansprüche, **dadurch gekennzeichnet, dass** die Brechungsindizes des transparenten Substrats (3), der transparenten Elektrode (4) und der organischen Elektrolumineszenzschicht (5) um weniger als 0,1 differieren und vorzugsweise identisch sind.

7. Elektrolumineszenzlichtquelle nach einem der vorangegangenen Ansprüche, **dadurch gekennzeichnet, dass** die reflektierende Elektrode (9) ein Reflexionsvermögen von mehr als 90% aufweist.

8. Elektrolumineszenzlichtquelle nach einem der vorangegangenen Ansprüche, **dadurch gekennzeichnet, dass** das Substrat (3) eine Lichtextraktionsstruktur (2) an der Grenzfläche mit der Luft aufweist.

## Revendications

1. Source lumineuse électroluminescente comprenant un substrat transparent (3), une électrode transparente (4), une électrode réfléchissante (9) et au moins une couche électroluminescente organique (5) pour émettre de la lumière, avec une épaisseur supérieure à 250 nm, de préférence supérieure à 400 nm, particulièrement supérieure à 500 nm, agencée entre les électrodes (4, 9), moyennant quoi la couche électroluminescente (5) comprend au moins une couche conductrice par trous (6) et une couche conductrice par électrons (8), **caractérisée en ce que** l'épaisseur de la couche conductrice par électrons (8) est supérieure à 200 nm, de préférence supérieure à 250 nm, particulièrement de préférence supérieure à 300 nm, et dans lequel la couche conductrice par électrons (8) et la couche conductrice par trous (6) possèdent des indices de réfraction nE et n_{L} avec une différence |nE-nL|<0,1.

2. Source lumineuse électroluminescente selon la revendication 1, **caractérisée en ce que** l'épaisseur de la couche conductrice par trous (6) est supérieure à 90 nm, de préférence supérieure à 150 nm, particulièrement de préférence supérieure à 200 nm.

3. Source lumineuse électroluminescente selon une quelconque des revendications précédentes 1 à 3, **caractérisée en ce que** la couche conductrice par électrons (8) contient des dopants de type n, de préférence des métaux, et/ou la couche conductrice par trous (6) contient des dopants de type p, de préférence des matériaux organiques, pour augmenter la conductivité.

4. Source lumineuse électroluminescente selon une quelconque des revendications précédentes, **caractérisée en ce que** la couche électroluminescente organique (5) possède une épaisseur de couche inférieure à 1000 nm, de préférence inférieure à 800 nm, particulièrement de préférence inférieure à 600 nm.

5. Source lumineuse électroluminescente selon une quelconque des revendications précédentes, **caractérisée en ce que** le substrat transparent (3) possède un indice de réfraction supérieur à 1,6, de préférence supérieur à 1,8.

6. Source lumineuse électroluminescente selon une quelconque des revendications précédentes, **caractérisée en ce que** les indices de réfraction du substrat transparent (3), de l'électrode transparente (4) et de la couche électroluminescente organique (5) diffèrent de moins de 0,1, et sont de préférence identiques.

7. Source lumineuse électroluminescente selon une quelconque des revendications précédentes, **caractérisée en ce que** l'électrode réfléchissante (9) possède une réflectivité supérieure à 90 %.

8. Source lumineuse électroluminescente selon une quelconque des revendications précédentes, **caractérisée en ce que** le substrat (3) possède une structure d'extraction de lumière (2) à l'interface avec l'air.
